# EUROPEAN PATENT APPLICATION

(11) **EP 1 024 595 A2**
(43) Date of publication of application: **02.08.2000**
(21) Application number: 00300609.5
(22) Date of filing: 27.01.2000
(51) Int. Cl.: H03K 5/08, H03K 5/1252

(54) **data discriminator**

(30) Priority: 28.01.1999 US 117653
(71) Applicant: Siemens Corporation, Auburn Hills, Michigan 48326 (US)
(72) Inventor: Thomas, Michael Anthony, Grand Blanc, Michigan 48439 (US)
(74) Representative: Vigars, Christopher Ian

(57) **Abstract**

A data discriminator circuit for discriminating between data pulses and noise pulses in a remote control system. The present data discriminator comprises an input element adapted to receive an input signal, and first and second signal output elements coupled to the input element and adapted to provide first and second time-varying signals, respectively, in response to the input signal. A comparator is coupled to the first and second signal output elements and provides an interrupt request signal when the magnitude of the first time varying signal exceeds the magnitude of the second time varying signal. A DC offset is added to the first time varying signal so that the magnitude of the first time varying signal initially exceeds the magnitude of the second time varying signal. A switch is also coupled to the first and second signal output elements and ground level, and connects the second output to ground level when the magnitude of the first time varying signal reaches a threshold level.

## Description

### BACKGROUND OF THE INVENTION

### 1. Field of the Invention.

The present invention relates to an apparatus and a method for discriminating between valid data pulses and random noise, and in particular, an apparatus and a method for recognizing valid data pulses in a remote control signal.

### 2. Related Art.

It is a common practice to control electronic devices using remote control signals, and such devices are often found in automobiles. In particular, it is common for an automobile to include a remote keyless entry system that allows a user to unlock the automobile locks or otherwise obtain access to the automobile using a remote control device.

In such a system, the user operates a remote control signal transmitter, usually contained within a key fob, to transmit an encoded message to a signal receiver disposed inside the vehicle. Typically, the remote control signals comprise RF signals that correspond to an encoded message that conforms to a particular signal protocol. The signal receiver comprises components that receive and process the remote control signals, and usually includes a super heterodyne receiver ("SHR"). A micro controller coupled to the signal receiver decodes the received message and determines whether the received message includes a valid access code. If the access code is valid, the micro controller unlocks the automobile's locks.

Modem vehicles utilize increased amounts of current in the vehicle off state which taxes the vehicle battery. Electronic systems must operate more efficiently to reduce current draw from the vehicle battery. In prior art remote keyless entry system, the signal receiver remains continuously energized in order to allow the user to unlock the signal receiver and may generate false interrupt request signals. A SHR also may generate occasional random logic level noise pulses due to the high sensitivity of the receiver. Filtering out the random wise pulses using software algorithms is problematic because the micro controller must first be energized in order to service the interrupt request signal. Frequent noise pulses may require the controller to be frequently energized in order to service the interrupt request signals and thereby draws current. Thus, both the signal receiver and the micro controller may draw significant current.

Therefore, what is needed is an apparatus and a method for discriminating between valid data pulses and noise pulses in a remote control system. In particular, what is needed is an apparatus and a method for filtering out noise pulses from a signal receiver such that power to the signal receiver can be cycled without causing the signal receiver to frequently generate and send false interrupt request signals to a micro controller.

### SUMMARY OF THE INVENTION

An object of the present invention is to fulfill the need referred to above. In accordance with the principles of the present invention, this objective is obtained by providing a data discriminator circuit for filtering out noise pulses from a signal receiver. The present data discriminator circuit filters out noise pulses and generates an interrupt request signal when a designated data stream is detected.

The present data discriminator circuit comprises an input element adapted to receive an input signal, a first signal output element coupled to the input element and adapted to provide a first time-varying signal in response to the input signal, and a second signal output element coupled to the input element and adapted to provide a second time-varying signal in response to the input signal. A comparator is coupled to the first and second signal output elements and adapted to provide an interrupt request signal in response to a predetermined relationship between the first and second time-varying signals.

In an exemplary embodiment, the first and second signal output elements comprise first and second RC networks that provide the first and second time varying signals to the comparator in response to an input signal. The first and second RC networks are arranged so that the second time varying signal increases at a faster rate than the first time varying signal in response to the input signal. The comparator generates an interrupt request signal when the second time varying signal exceeds the first time varying signal. A DC offset is added to the first varying signal so that the first time varying signal initially exceeds the second time varying signal. A switch is also coupled to the first and second signal output elements and ground level, and connects the second output to ground level when the first time varying signal reaches a threshold level.

### BRIEF DESCRIPTION OF THE DRAWINGS

The invention is described by reference to the accompanying drawings, wherein:
Fig. 1 is a block diagram illustrating a signal receiver utilizing the present invention data discriminator;
Fig. 2 is a graph illustrating noise pulses generated upon powering up the SHR;
Fig. 3 is a graph illustrating a random nose pulse generated after the SHR has been powered up;
Fig. 4 is a circuit diagram showing a data discriminator circuit in accordance with the present invention;
Fig. 5 is a graph illustrating a data stream and inputs provided to op-amp of Fig. 4 in response to the-data stream;
Fig. 6 is a graph illustrating noise pulses generated upon powering up the SHR without generating an interrupt request signal;
Fig. 7 is a graph illustrating noise pulses generated upon powering up the SHR without an interrupt request being generated;
Fig. 8 is a graph illustrating noise pulses generated upon powering up the SHR followed by a data stream, and an interrupt request signal being generated in response to the data stream;
Fig. 9 is a graph illustrating a noise pulse that goes into a steady state DC condition and inputs provided to operational amplifier of Fig. 4 in response to the noise and the DC condition; and
Fig. 10 is a graph illustrating four data packets, interrupt requests generated in response to the data packets and inputs provided to operational amplifier of Fig. 4 in response to the data packets.

### DETAILED DESCRIPTION OF AN EXEMPLARY EMBODIMENT

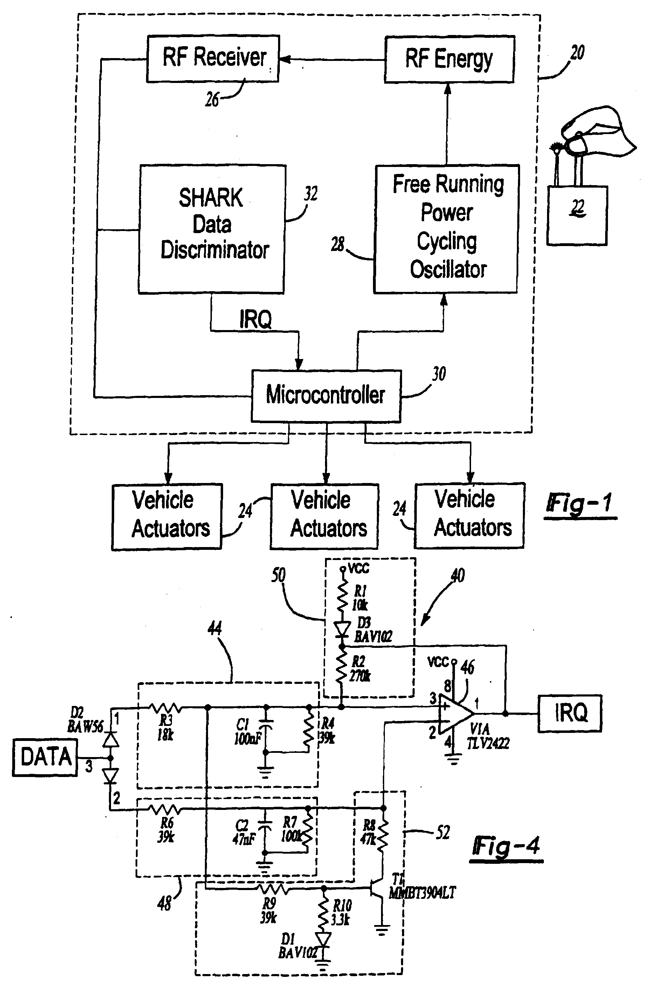

Figure 1 shows a signal receiver 20 that receives RF signal from a user activated transmitter 22, such as a key fob. The signal receiver 20 may be used in a vehicle for remotely actuating door lock actuators 24. The signal receiver 20 includes an RF receiver 26, preferably a super heterodyne receiver ("SHR"), where the RF signal form the transmitter is demodulated. The RF signal contains data packets that include a wake up pulse and encoded data having the coded bits necessary to actuate the locks, which is discussed in more detail below. A free running power cycling oscillator 28 is connected to the SHR 26 for turning the SHR 26 on and off while the SHR 26 is waiting to receive data thereby conserving power.

The SHR 26 is connected to a micro controller 30 and the present invention data discriminator 32 for providing an input signal to each. Previously, an interrupt request was sent from the SHR 26 to the micro controller 30 each time any signal was received, which turned on the micro controller 30 to determine whether there was valid data in the signal. With the present invention data discriminator 32, noise is filtered from the input signal sent by the SHR 26 so that only signals containing valid data generate an interrupt request signal that turns on the micro controller 30. In this manner, the interrupt request signal no longer comes directly from the SHR 26, but is instead generated by the data discriminator 32 after it has determined that the input signal from the SHR 26 is valid data and not noise. The micro controller 30 is connected to the oscillator 28 so that once the micro controller 30 receives the interrupt request signal the oscillator 28 is shut down so that the SHR will continue to send data to the micro controller 30 for processing.

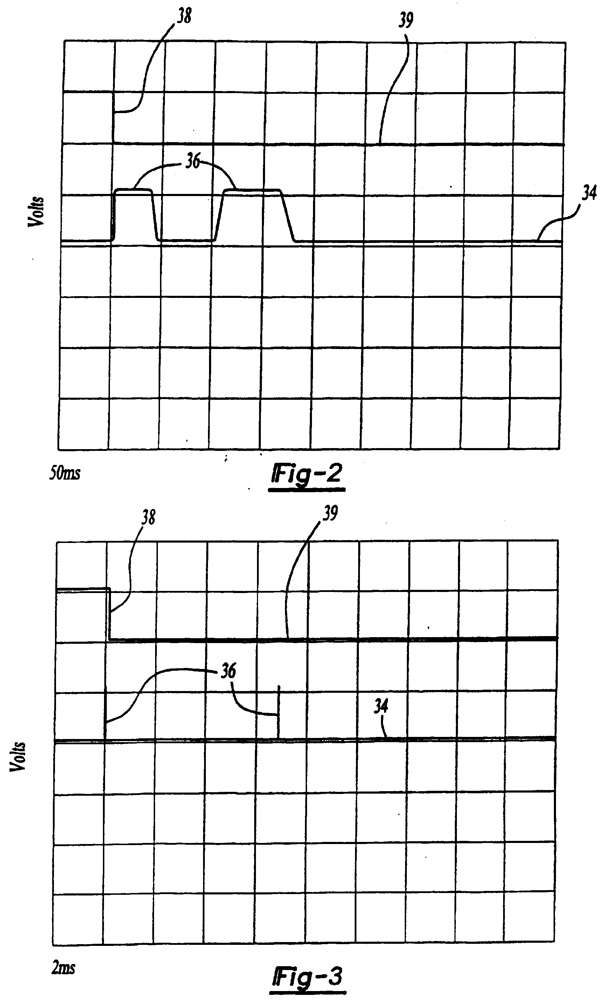

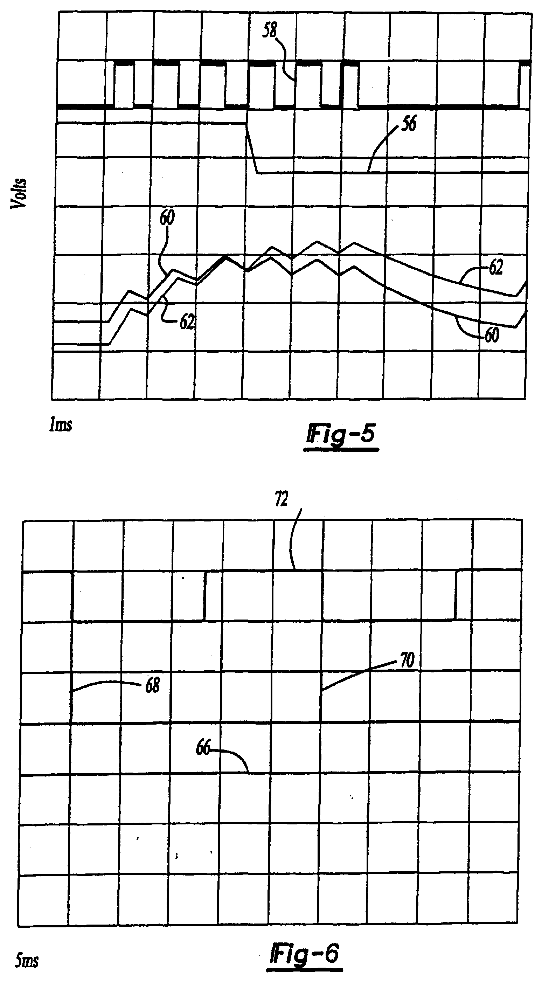

Figs. 2 and 3 illustrate noise generated by the SHR 26 when it is turned on by the oscillator 28. Input signal 34 contains noise 36 when the SHR 26 is switched on, indicated by a falling edge 38 in SHR power signal 39. With reference to Fig. 4, circuit 40 illustrates a data discriminator circuit in accordance with the present invention. Circuit 40 receives an input signal from the SHR 26 via input terminal DATA and provides an interrupt request signal to the micro controller 30 via output terminal IRQ when a valid data stream is detected. The construction and operation of suitable SHRs and micro controllers are well known in the art and will not be disclosed in detail here. It is to be understood that the present invention is suitable for use with any receiver capable of receiving and processing remote control signals and any micro controller capable of processing the received messages and providing control functions.

In the present invention, circuit 40 generates the interrupt request signal when four bits encoded in the so-called Manchester message format is received at input DATA. In the so-called Manchester message format, the period for each bit is about 500 us, or a based rate of approximately 1000 bits per second, with a 50% duty the bit value is determined by a transition at the 50% point. In this format, a transition from high to low represents a "0" and a transition from low to high represents a "1". It is to be understood that the component values of circuit 40 may be adjusted as desired to respond to different message validation formats, i.e., receipt of a different number of bits.

The input signal from the SHR 26 is received at input element DATA and provided to operational amplifier V1A through the signal output elements described below. Input DATA is coupled to common anode dual diode D2. Cathode 1 of diode D2 is coupled to a first signal output element 44 that includes RC network comprising resistor R3 and capacitor C1 which in turn is coupled to positive input 3 of a comparator 46, or op-amp V1A. Cathode 2 of diode D2 is coupled to a second signal output element 48 that includes RC network comprising resistor R6 and capacitor C2 which in turn is coupled to negative input 2 of op-amp V1A.

Resistor R3 and capacitor C1 determine the time constant for controlling the rate of increase in voltage at positive input 3 when the input signal at input DATA is high. Capacitor C1 discharges via a complex network that consists of R4, R9, R10, D1 and T1 when the input signal at input DATA is low. It is to be understood that high and low input signals refers to those input signals that cause the voltage at inputs 2 and 3 to increase and decrease, respectfully, and not to specific voltage levels. VCC, resistors R1 and R2, and diode D3 provide a continuous DC offset 50 at positive input 3.

Resistor R6 and capacitor C2 determine the time constant for controlling the rate of increase in voltage at negative input 2 when the input signal at input DATA is high. Capacitor C2 discharges via resistor R7 when the input signal at input DATA is low. Capacitor C2 may also discharge through an active discharge element 52 via resistor R8 and transistor T1 when transistor T1 is turned ON. It can be seen that turning ON transistor T1 prevents the voltage at negative input 2 from exceeding the voltage at positive input 3. Transistor T1 is turned ON when the voltage at positive input 3 exceeds a predetermined threshold level. Resistors R9 and R10 establish the bias voltage at the base of transistor T1. Diode D1 provides thermal stability.

Op-amp V1A generates an interrupt request signal at output IRQ by providing a low output signal when the voltage at negative input 2 exceeds the voltage at positive input 3.

In circuit 40, the values of R3, R6, C1 and C2 are selected so that the voltage at negative input 2 increases at a faster rate than the voltage at positive input 3 when the input signal at input DATA is high. Also the values of R4 and R7 are selected so that the voltage at negative input 2 decreases at a slower rate than the voltage at positive input 3 when the input signal at input DATA is low. However, the voltage at positive input 3 is initially higher than the voltage at negative input 2 due to the continuous DC offset. Therefore, a series of data pulses must be received at input DATA before the voltage at negative input 2 exceeds the voltage at positive input 3, and thereby generate an interrupt request signal. In the present embodiment, at least four successive valid data pulses must be received before an interrupt signal is generated. However, it is to be understood that circuit 40 may be adapted for use with other message protocols by adjusting the component values to reflect an alternative data pulse arrangement that must be received before an interrupt request signal is generated.

Circuit 40 operates as follows. When a high input signal is received at input DATA, the input voltage at positive input 3 of op-amp V1A begins to increase in accordance with the time constant determined by R3 and C1. Likewise, the input voltage at negative input 2 of op-amp V1A begins to increase in accordance with the time constant determined by R6 and C2. Here, the time constants R3*C1 and R6*C2 are set so that the input voltage at negative input 2 increases at a faster rate than the input voltage at positive input 3. However, the magnitude of the input at input 3 initially remains above the magnitude of the input at negative input 2 due to the DC bias provided through R1, D3 and R2, and thus, the output IRQ remains high. When the input signal at input DATA goes low, C1 and C2 discharge through their respective discharge paths.

In this manner, each successive data pulse applies more charge to C1 and C2. After the fourth data pulse of the Manchester format, the voltage at negative input 2 becomes greater than the voltage at positive input 3. At that point, output 1 of op-amp V1A goes low, thereby generating an interrupt request signal at output IRQ. Therefore, at least four data pulses must be received before circuit 40 generates an interrupt request signal. This is shown in Fig. 5, wherein the interrupt request signal 56 is generated upon receipt of the fourth data pulse 58. Inputs 60 and 62 illustrate the input signals to positive input 3 and negative input 2, respectively, wherein the interrupt request signal 56 is generated when input 62 exceeds input 60.

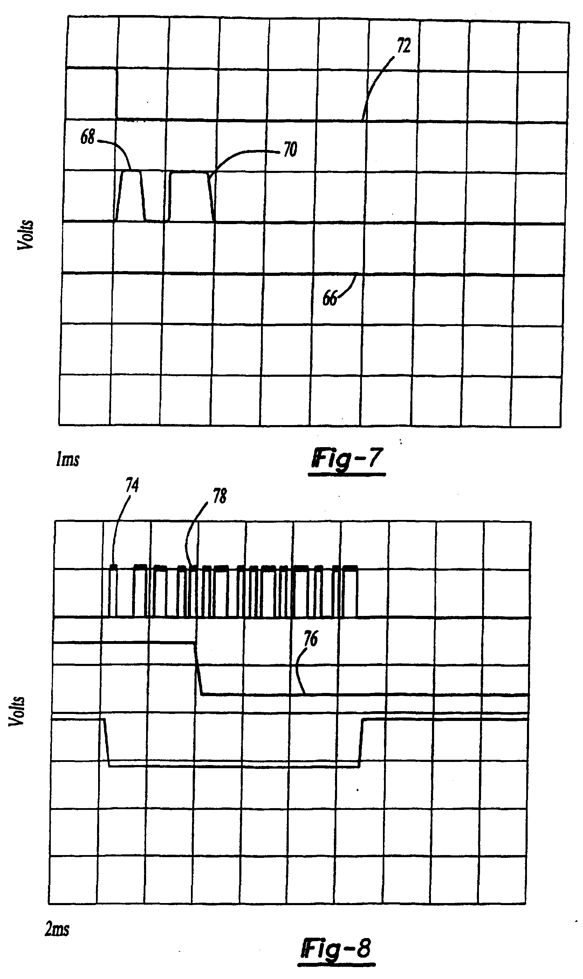

If random, spurious noise pulses are received, the voltage at negative input 2 will not exceed the voltage at positive input 3. This is due to the fact that the DC bias at positive input 3 and the relative discharge rates of capacitors C1 and C2 will maintain the voltage differential at inputs 2 and 3. The voltage differential at inputs 2 and 3 prevents op-amp V1A from generating an interrupt request. This is shown in Figs. 6 and 7, wherein the output 66 at IRQ remains high in spite of noise pulses 68 and 70 at DATA from turning the SHR on, shown by signal 72. Fig. 8 illustrates that noise 74 at DATA from turning on the SHR 26 will not send an interrupt request 76 until the wake up pulse 78 is received..

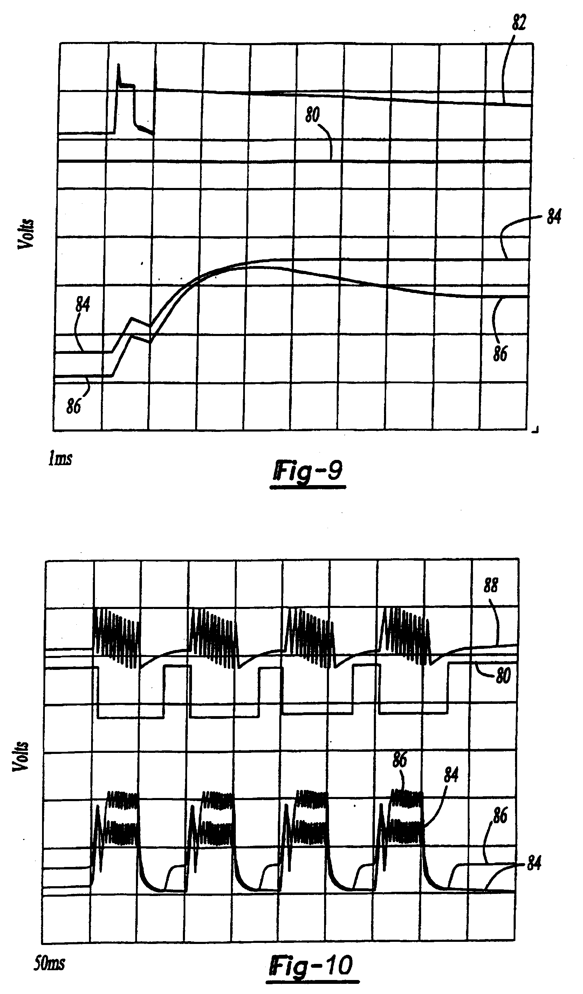

In the event of a DC pulse, the voltage at positive input 3 turns ON transistor T1 thereby discharging C2 through R8 and T1. Due to the DC bias, the voltage at positive input 3 reaches the threshold to turn ON transistor T1 before the voltage at negative input 2 gets high enough to generate an interrupt request signal. Thereafter, the discharging of C2 prevents the voltage at negative input 2 from exceeding the voltage at positive input 3. Since the voltage at positive input 3 remains higher than the voltage at negative input 2, an invalid interrupt request signal is not generated at output IRQ. This is shown in Fig. 9, wherein the output 80 at IRQ stays high in spite of noise pulse 82 going to a DC state. Inputs 84 and 86 illustrate the input signals to positive input 3 and negative input 2, respectively. Fig. 10 illustrates the output 80 at IRQ for four data packets 88 sent by the transmitter 22.

Although the invention has been described by reference to a specific embodiment, it should be understood that numerous changes may be made within the spirit and scope of the inventive concepts described. For example, the receiver may be adapted to receive other types of remote control signals, including, but not limited to, IR or ultrasonic signals. Furthermore, circuit 40 may be incorporated as a portion of the signal receiver or the micro controller in a single integrated package. Accordingly, it is intended that the invention not be limited to the described embodiment, but that it includes all modifications encompassed within the spirit of the following claims.

## Claims

1. A data discriminator circuit for filtering a signal, comprising:
an input clement receiving an input signal including data at a desired baud rate and a desired duty cycle;
a first signal output element coupled to said input element producing a first time-varying signal in response to said input signal;
a second signal output element coupled to said input element producing a second time-varying signal different from said first time varying signal in response to said input signal, said data producing a first differential between said first and said second time-varying signals; and
a comparator coupled to said first and second signal output elements, said comparator producing an interrupt request signal in response to said first differential.

2. The data discriminator circuit according to claim 1, wherein said first and second time-varying signals increase at first and second rates, respectively, when said input signal is above a first threshold level, said second rate being higher than said first rate, and said first and second time-varying signals decrease at third and fourth rates, respectively, when said input signal is below said first threshold level, said third rate being higher than said fourth rate.

3. The data discriminator circuit according to claim 2, further comprising a power supply coupled to said first signal output element, said power supply providing a constant DC offset to said first time-varying signal.

4. The data discriminator circuit according to claim 3, wherein said second time varying signal exceeding said first time varying signal produces said first differential.

5. The data discriminator circuit according to claim 4, wherein said input signal also includes high frequency noise, said high frequency noise producing a second differential between said first and said second time-varying signals, and said comparator withholding said interrupt signal in response to said second differential.

6. The data discriminator circuit according to claim 4, wherein said comparator comprises an operational amplifier comparator.

7. The data discriminator circuit according to claim 4, further comprising an active discharge network coupled to said first and second signal output elements and ground level, wherein said input signal further includes low frequency noise, and wherein said active discharge network couples said second signal output element to ground level when said low frequency noise produces a first time-varying signal exceeding a second threshold level.

8. The data discriminating circuit according to claim 7, wherein said active discharge network includes a transistor coupling said second signal output element to ground above said second threshold level.

9. The data discriminator circuit according to claim 2, wherein said first signal output element comprises first and second RC networks, and said second signal output element comprises third and fourth RC networks.

10. The data discriminator circuit according to claim 2, wherein said first and said second rates cause said second time varying signal to exceed said first time varying signal when said input signal comprises a four bit data stream that conforms to the Manchester message format.

11. The data discriminating circuit according to claim 10, wherein said desired duty cycle is fifty percent and said desired baud rate is approximately 1000 bits per second.

12. A remote signal receiver unit for a vehicle for receiving an RF signal that actuates a vehicle component, comprising;
a signal receiver for receiving said signal and producing an input signal including data having a wake up pulse and a code;
a micro controller coupled to said signal receiver and having normal sleep and power modes, said micro controller actuating the vehicle component when receiving said code in said power mode;
a first signal output element coupled to said signal receiver producing a first time-varying signal in response to said input signal;
a second signal output element coupled to said signal receiver producing a second time-varying signal different from said first time varying signal in response to said input signal, said wake up pulse producing a first differential between said first and said second time-varying signals;
a comparator coupled to said first and second signal output elements and to said micro controller, said comparator producing an interrupt request signal in response to said first differential to switch said micro controller from said normal sleep mode to said power mode; and
an active discharge network coupled to said first and second signal output elements and round level, wherein said active discharge network couples said second signal output element to ground level when said first time-varying signal exceeds a second threshold level.

13. The remote signal receiver unit according to claim 12, wherein said first and second time-varying signals increase at first and second rates respectively, when said input signal is above a first threshold level, said second rate being higher than said first rate, and said first and second time-varying signals decrease at third and fourth rates, respectively, when said input signal is below said first threshold level, said third rate being higher than said fourth rate.

14. The remote signal receiver unit according to claim 13, further comprising a power supply coupled to said first signal output element, said power supply providing a constant DC offset to said first time-varying signal.

15. The remote signal receiver unit according to claim 14, wherein said second time varying signal exceeding said first time varying signal produces said first differential.

16. The remote signal receiver unit according to claim 15, wherein said input signal also includes noise, said noise producing said second threshold level and a second differential between said first and said second time-varying signals said comparator withholding said interrupt signal in response to said second threshold level and said second differential.

17. The remote signal receiver unit according to claim 15, wherein said comparator comprises an operational amplifier.

18. The remote signal receiver unit according to claim 15, wherein said active discharge network includes a transistor coupling said second signal output element to ground above said second threshold level.

19. The remote signal receiver unit according to claim 13, wherein said first and said second signal output elements comprise first and second RC networks, respectively.

20. The remote signal receiver unit according to claim 13, wherein said first and said second rates cause said second time varying signal to exceed said first time varying signal when said input signal comprises a four bit data stream that conforms to the Manchester message format.

21. The remote signal receiver unit according to claim 12, further comprising a power cycling oscillator coupled to said signal receiver and said micro controller, wherein said signal receiver and said power cycling oscillator each include on and off modes, said power cycling oscillator switching said signal receiver between said on and said off modes when said power cycling oscillator is in said on mode, said micro controller switching said power cycling oscillator from said on mode to said off mode when in said power mode.

22. The remote signal receiver unit according to claim 12, wherein the signal receiver comprises a super heterodyne receiver for demodulating said input signal.

23. A method of filtering noise in an input signal from a signal receiver, comprising the steps of:
a) receiving the input signal having a wake up pulse;
b) generating first and second time-varying signals based upon the input signal;
c) comparing the first and second time-varying signals; and
d) producing an interrupt request signal in response to the wake up pulse.

24. The method according to claim 23, wherein the input signal includes noise, further including the step of:
e) distinguishing between the noise and the wake up pulse and withholding the interrupt request signal in response to the noise.

25. The method according to claim 24, further comprising the step of:
f) demodulating the input signal, wherein step f) occurs after step a).

26. The method according to claim 24, further comprising the steps of:
g) increasing the first and second time-varying signals at first and second rates, respectively, when the input signal is above a first threshold, the second rate being higher than the first rate;
h) decreasing the first and second time-varying signals at third and fourth rates, respectively, when the input signal is below the first threshold, the third rate being higher that the fourth rate, wherein steps g) and h) occur after step b).

27. The method according to claim 26, further comprising the step of:
i) offsetting the first time-varying signal by a constant DC voltage, wherein step i) occurs prior to step g).

28. The method according to claim 27, wherein step d) includes producing the interrupt request signal in response to the wake up pulse when the second time-varying signal exceed said first time-varying signal.

29. The method according to claim 27, further comprising the step of:
k) grounding the second time-varying signal when the noise produces a first time-varying signal exceeding a second threshold level, wherein step k) occurs prior to step c).
